# EUROPEAN PATENT APPLICATION

(11) **EP 4 560 773 A1**
(43) Date of publication of application: **28.05.2025**
(21) Application number: 23913942.1
(22) Date of filing: 03.01.2023
(51) Int. Cl.: H01M 10/42

(54) **PEROVSKITE SOLAR CELL, MANUFACTURING METHOD THEREFOR, AND ELECTRICAL DEVICE**

(71) Applicant: Contemporary Amperex Technology (Hong Kong) Limited, Hong Kong (HK)
(72) Inventor: TU, Bao, Ningde, Fujian 352100 (CN); CHEN, Changsong, Ningde, Fujian 352100 (CN); LIANG, Weifeng, Ningde, Fujian 352100 (CN); GUO, Wenming, Ningde, Fujian 352100 (CN); GUO, Yongsheng, Ningde, Fujian 352100 (CN); CHEN, Guodong, Ningde, Fujian 352100 (CN)
(74) Representative: Jacob, Reuben Ellis
(86) International application number: PCT/CN2023/070215
(87) International publication number: WO 2024/145782

(57) **Abstract**

Disclosed in the present invention are a perovskite solar cell, a manufacturing method therefor, and an electrical device. The perovskite solar cell comprises: a perovskite light-absorption layer, an electron transport layer, and a resistance reduction layer located between the perovskite light-absorption layer and the electron transport layer. Therefore, the resistance reduction layer can reduce the residual Schottky barrier between the interfaces of the perovskite light-absorption layer and the electron transport layer, thereby reducing the contact resistance between the perovskite light-absorption layer and the electron transport layer, and improving the fill factor of a perovskite solar cell device.

## Description

### TECHNICAL FIELD

The present invention relates to the field of solar cell technologies, and specifically to a perovskite solar cell, a preparation method thereof, and an electric device.

### BACKGROUND

Perovskite solar cells are a novel solar cell technology that has developed prosperously in recent years. Perovskite solar cells are solar cells that use perovskite-type organic metal halide semiconductors as light-absorbing materials and belong to the third generation of solar cells, also known as new-concept solar cells. In recent years, perovskite solar cells have attracted much attention due to their abundant raw material reserves, simple preparation process, and ability to achieve record-breaking high efficiency using low-temperature and low-cost processes.

The contact resistance between film layers in perovskite solar cells directly affects fill factors of devices. Therefore, it is of great significance to develop a perovskite solar cell in which interface contact resistance can be reduced.

### SUMMARY

In view of this, the present invention provides a perovskite solar cell. The perovskite solar cell includes: a perovskite light absorbing layer, an electron transport layer, and a resistance reduction layer located between the perovskite light absorbing layer and the electron transport layer. Thus, the resistance reduction layer can reduce residual Schottky barrier potential at an interface between the perovskite light absorbing layer and the electron transport layer, reduce contact resistance between the perovskite light absorbing layer and the electron transport layer, and increase a fill factor of a perovskite solar cell device.

According to embodiments of the present invention, a material for forming the resistance reduction layer includes at least one of metal sulfide, metalloid sulfide, and sulfur-containing organic compound. This can effectively reduce contact resistance between the perovskite light absorbing layer and the electron transport layer and increase a fill factor of a perovskite solar cell device.

According to the embodiments of the present invention, the material for forming the resistance reduction layer includes at least one of lithium sulfide, potassium sulfide, magnesium sulfide, arsenic sulfide, indium sulfide, manganese sulfide, and cobalt sulfide. This can effectively improve the performance of the perovskite solar cell.

According to the embodiments of the present invention, a thickness of the resistance reduction layer is less than or equal to 3 nm. This can effectively reduce contact resistance between the perovskite light absorbing layer and the electron transport layer and effectively increase a fill factor of a perovskite solar cell device.

According to the embodiments of the present invention, the thickness of the resistance reduction layer is 1 nm to 3 nm. This can effectively reduce residual Schottky barrier potential at the interface between the perovskite light absorbing layer and the electron transport layer and increase a fill factor of a perovskite solar cell device.

According to the embodiments of the present invention, the perovskite solar cell further includes a back electrode layer, a transparent electrode layer, and a hole transport layer; This can further improve the performance of the perovskite solar cell.

According to the embodiments of the present invention, the transparent electrode layer is located on a side of the electron transport layer away from the resistance reduction layer, the hole transport layer is located on a side of the perovskite light absorbing layer away from the resistance reduction layer, and the back electrode layer is located on a side of the hole transport layer away from the perovskite light absorbing layer. Thus, the structure of the perovskite solar cell is formed by stacked layers: the transparent electrode layer, the electron transport layer, the resistance reduction layer, the perovskite light absorbing layer, the hole transport layer, and the back electrode layer. That is, the perovskite solar cell of the present invention may include a cis device structure.

According to the embodiments of the present invention, the hole transport layer is located on the side of the perovskite light absorbing layer away from the resistance reduction layer, the transparent electrode layer is located on the side of the hole transport layer away from the perovskite light absorbing layer, and the back electrode layer is located on the side of the electron transport layer away from the resistance reduction layer. Thus, the structure of the perovskite solar cell is formed by stacked layers: the transparent electrode layer, the hole transport layer, the perovskite light absorbing layer, the resistance reduction layer, the electron transport layer, and the back electrode layer. That is, the perovskite solar cell of the present invention may include a trans device structure.

According to the embodiments of the present invention, the perovskite solar cell satisfies at least one of the following conditions: a material for forming the transparent electrode layer includes at least one of FTO, ITO, AZO, BZO, and IZO; a chemical formula of a material for forming the perovskite light absorbing layer is ABX₃ or A₂CDX₆, where A is at least one of methylamino, amidino, cesium ion, and rubidium ion, B is at least one of divalent lead ion and divalent tin ion, C is monovalent silver ion, D is trivalent bismuth ion, and X is at least one of chloride ion, bromide ion, and iodide ion; a band gap of the perovskite light absorbing layer is 1.20 eV to 2.30 eV; a thickness of the perovskite light absorbing layer is 200 nm to 1000 nm; a material for forming the electron transport layer includes at least one of [6,6]-phenyl C₆₁ methyl butyrate, [6,6]-phenyl C₇₁ methyl butyrate, fullerene C60, fullerene C70, tin dioxide, and zinc oxide; a material for forming the hole transport layer includes at least one of poly[bis(4-phenyl)(2,4,6-trimethylphenyl)amine], 2,2',7,7'-tetra[N,N-bis(4-methoxyphenyl)amino]-9,9'-spirobifluorene, poly-3-hexylthiophene, triphenylamine with triptycene as a core, 3,4-ethylenedioxythiophene-methoxytriphenylamine, N-(4-aniline) carbazole-spirobifluorene, poly(3,4-ethylenedioxythiophene), poly(styrenesulfonate), polythiophene, nickel oxide, molybdenum oxide, copper iodide, and cuprous oxide; and a material for forming the back electrode layer includes at least one of Ag, Cu, C, Au, Al, ITO, AZO, BZO, and IZO. This can further improve the performance of the perovskite solar cell.

The present invention further provides a method for preparing the perovskite solar cell described above. The method includes: forming a resistance reduction layer between a perovskite light absorbing layer and an electron transport layer through evaporation. Therefore, the method has all the features and advantages of the perovskite solar cell described above, which are not described again herein. In conclusion, a perovskite solar cell device prepared using this preparation method has a high fill factor. In addition, the method also has the advantage of simple operation.

According to the embodiments of the present invention, an evaporation rate is 0.005 A/s to 0.03 A/s. Thus, a resistance reduction layer with a compact structure can be obtained.

According to the embodiments of the present invention, after the evaporation is completed, the method further includes a step of vacuumizing a chamber, where the vacuumizing is performed for 20 min to 40 min. This enables the obtained perovskite solar cell to have better performance.

According to the embodiments of the present invention, the method includes: providing a transparent electrode layer; forming the electron transport layer on a side of the transparent electrode layer; forming the resistance reduction layer on a side of the electron transport layer away from the transparent electrode layer; forming the perovskite light absorbing layer on a side of the resistance reduction layer away from the electron transport layer; forming a hole transport layer on a side of the perovskite light absorbing layer away from the resistance reduction layer; and forming a back electrode layer on a side of the hole transport layer away from the perovskite light absorbing layer. In this way, a perovskite solar cell with a cis structure can be prepared.

According to the embodiments of the present invention, the method includes: providing a transparent electrode layer; forming a hole transport layer on a side of the transparent electrode layer; forming the perovskite light absorbing layer on a side of the hole transport layer away from the transparent electrode layer; forming the resistance reduction layer on a side of the perovskite light absorbing layer away from the hole transport layer; forming an electron transport layer on a side of the resistance reduction layer away from the perovskite light absorbing layer; and forming a back electrode layer on a side of the electron transport layer away from the resistance reduction layer. In this way, a perovskite solar cell with a trans structure can be prepared.

The present invention further provides an electric device. The electric device includes the perovskite solar cell described above. Therefore, the electric device has all the features and advantages of the perovskite solar cell described above, which are not described again herein. In conclusion, the perovskite solar cell in the electric device has excellent performance.

### BRIEF DESCRIPTION OF DRAWINGS

FIG. 1 is a schematic structural diagram of a perovskite solar cell according to an embodiment of the present invention;
FIG. 2 is a schematic structural diagram of a perovskite solar cell according to another embodiment of the present invention; and
FIG. 3 is a schematic structural diagram of a perovskite solar cell according to another embodiment of the present invention.

### Description of reference signs

100. perovskite light absorbing layer; 200. resistance reduction layer; 300. electron transport layer; 400. hole transport layer; 500. transparent electrode layer; and 600. back electrode layer.

### DESCRIPTION OF EMBODIMENTS

The following explains solutions of the present invention with reference to embodiments. Persons skilled in the art will understand that the following embodiments are merely intended to illustrate the present invention rather than to limit the scope of the present invention. Examples whose technical solutions or conditions are not specified are made in accordance with technical solutions or conditions described in literature in the field, or made in accordance with product instructions. The reagents or instruments used are all conventional products that are commercially available if no manufacturer is indicated.

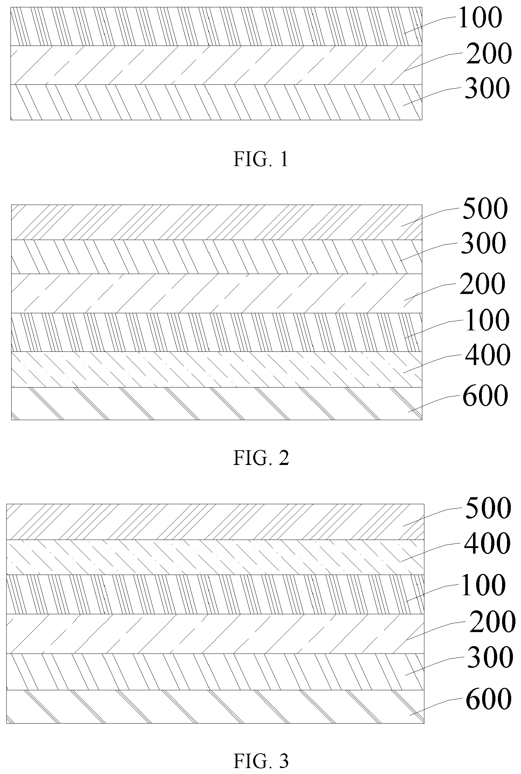

The present invention provides a perovskite solar cell. Referring to FIG. 1, the perovskite solar cell includes: a perovskite light absorbing layer 100, an electron transport layer 300, and a resistance reduction layer 200 located between the perovskite light absorbing layer 100 and the electron transport layer 300. Thus, the resistance reduction layer 200 can reduce residual Schottky barrier potential at an interface between the perovskite light absorbing layer 100 and the electron transport layer 300, reduce contact resistance between the perovskite light absorbing layer 100 and the electron transport layer 300, and increase a fill factor of a perovskite solar cell device. In addition, the resistance reduction layer 200 can also reduce interface defect states and reduce non-radiative recombination, and can further improve device efficiency and batch stability.

For ease of understanding, the following first briefly describes the principles by which the perovskite solar cell of this application can achieve the above beneficial effects.

As described above, the contact resistance between the film layers of the cell affects the fill factor of the device, so the performance of the cell cannot be fully improved and exerted. In the related art, the above technical problem can be alleviated by preparing a passivation layer between the perovskite light absorbing layer and the hole transport layer. Specifically, in the related art, after perovskite is prepared, a passivation layer is prepared on the perovskite using a solution method, so that interface contact quality is improved and closer interface contact is achieved, reducing defect states, and improving device efficiency and stability to some extent. However, in a preparation process in this method, heating is required for preparing the passivation layer, but in during heating treatment, a part of a passivation layer material may decompose upon heating. As a result, this method brings a problem of poor reproducibility, leading to poor batch stability of the device. In this application, a layer of material is inserted as a resistance reduction layer between the perovskite light absorbing layer and the electron transport layer, and the thickness, compactness, and the like of the sulfides can be precisely controlled using an evaporation device, thereby further improving the batch stability of the device while passivating interface defect states and reducing non-radiative recombination. The material of the resistance reduction layer can optimize the interface between the electron transport layer and the perovskite light absorbing layer, increase an interface contact area, reduce interface defect states, reduce residual Schottky barrier potential between the electron transport layer and the perovskite light absorbing layer, and reduce contact resistance, thereby improving current carrier transport capability at this location. In addition, the resistance reduction layer with a specific thickness can be formed by methods including but not limited to evaporation, thereby controlling a specific thickness and improving the reproducibility of the device.

According to the embodiments of the present invention, a material for forming the resistance reduction layer 200 includes at least one of metal sulfide, metalloid sulfide, and sulfur-containing organic compound. Thus, the resistance reduction layer 200 can effectively reduce contact resistance between the perovskite light absorbing layer 100 and the electron transport layer 300. Specifically, uncoordinated lead is present in the perovskite light absorbing layer 100, and sulfur in the resistance reduction layer 200 can interact with the uncoordinated lead in the perovskite light absorbing layer 100, forming a chemical bond between the sulfur and the lead, thereby reducing interface defect states and reducing contact resistance.

The metal sulfide includes but is not limited to alkali metal sulfide, alkaline-earth metal sulfide, and transition metal sulfide.

The metalloid sulfide refers to a compound formed by metalloid and sulfur, where the physical and chemical properties of the metalloid are between those of metals and non-metals, the metalloid includes boron, silicon, germanium, selenium, tellurium, polonium, arsenic, and antimony. Further, the metalloid sulfide includes boron sulfide, silicon sulfide, germanium sulfide, selenium sulfide, tellurium sulfide, polonium sulfide, arsenic sulfide, and antimony sulfide.

The sulfur-containing organic compound an organic compound that is substituted by one, two, or more sulfur-containing functional groups. Specifically, the sulfur-containing organic compound is an aliphatic hydrocarbon compound or aromatic hydrocarbon compound substituted by one, two, or more thiol groups (-SH) and sulfonic acid groups (-SO₃H). For example, the sulfur-containing compound includes but is not limited to butane sulfonic acid and benzene sulfonic acid.

According to the embodiments of the present invention, the material for forming the resistance reduction layer 200 includes at least one of lithium sulfide, potassium sulfide, magnesium sulfide, arsenic sulfide, indium sulfide, manganese sulfide, and cobalt sulfide. This can effectively improve the performance of the perovskite solar cell.

According to the embodiments of the present invention, a thickness of the resistance reduction layer 200 is less than or equal to 3 nm. This can effectively reduce contact resistance between the perovskite light absorbing layer 100 and the electron transport layer 300 and increase a fill factor of a perovskite solar cell device. An excessively large thickness of the resistance reduction layer 200 hinders electron transport, reducing the performance of the perovskite solar cell.

According to some embodiments of the present invention, the thickness of the resistance reduction layer 200 may be 1 nm to 3 nm, specifically 1 nm, 1.5 nm, 2 nm, 2.5 nm, or 3 nm. The resistance reduction layer 200 with a thickness within the above range can be easily formed by methods including but not limited to evaporation, avoids a failure in forming a continuous film layer due to an excessively small thickness, and does not hinder current carrier transport at the interface, reduce the contact resistance or reduce the fill factor due to an excessively large thickness.

According to the embodiments of the present invention, the perovskite solar cell further includes a back electrode layer 600, a transparent electrode layer 500, and a hole transport layer 400. This can further improve the performance of the perovskite solar cell.

According to the embodiments of the present invention, referring to FIG. 2, the transparent electrode layer 500 is located on a side of the electron transport layer 300 away from the resistance reduction layer 200, the hole transport layer 400 is located on a side of the perovskite light absorbing layer 100 away from the resistance reduction layer 200, and the back electrode layer 600 is located on a side of the hole transport layer 400 away from the perovskite light absorbing layer 100. Thus, the structure of the perovskite solar cell is formed by stacked layers: the transparent electrode layer 500, the electron transport layer 300, the resistance reduction layer 200, the perovskite light absorbing layer 100, the hole transport layer 400, and the back electrode layer 600. That is, the perovskite solar cell of the present invention may include a cis device structure. For a formal perovskite solar cell, the introduction of the resistance reduction layer 200 can not only reduce the interface contact resistance but also increase a binding strength between the resistance reduction layer 200 and lead in a perovskite precursor solution, thereby improving the crystallization quality of the perovskite, and improving the stability of the device. Specifically, the perovskite precursor solution contains uncoordinated lead that can interact with the sulfur in the resistance reduction layer 200, so that a chemical bond is formed between the sulfur and the lead, thereby allowing for a large binding strength between the resistance reduction layer 200 and the perovskite light absorbing layer 100.

According to some other embodiments of the present invention, referring to FIG. 3, the hole transport layer 400 is located on the side of the perovskite light absorbing layer 100 away from the resistance reduction layer 200, the transparent electrode layer 500 is located on the side of the hole transport layer 400 away from the perovskite light absorbing layer 100, and the back electrode layer 600 is located on the side of the electron transport layer 300 away from the resistance reduction layer 200. Thus, the structure of the perovskite solar cell is formed by stacked layers: the transparent electrode layer 500, the hole transport layer 400, the perovskite light absorbing layer 100, the resistance reduction layer 200, the electron transport layer 300, and the back electrode layer 600. That is, the perovskite solar cell of the present invention may include a trans device structure. For a trans perovskite solar cell, the resistance reduction layer 200 can reduce the interface contact resistance, and the resistance reduction layer 200 can also serve as a protective layer for the electron transport layer 300, preventing unnecessary ion migration and the like caused by direct contact between migrating ions and the back electrode layer 600.

According to the embodiments of the present invention, the material for forming the transparent electrode layer 500 includes at least one of FTO, ITO, AZO, BZO, and IZO.

According to the embodiments of the present invention, a chemical formula of a material for forming the perovskite light absorbing layer 100 is ABX₃ or A₂CDX₆, where A is at least one of methylamino (CH₃NH₃⁺), amidino (HC(NH₂)₂⁺), cesium ion (Cs⁺), and rubidium ion (Rb⁺), B is at least one of divalent lead ion (Pb²⁺) and divalent tin ion (Sn²⁺), C is monovalent silver ion (Ag⁺), D is trivalent bismuth ion (Bi³⁺), and X is at least one of chloride ion (Cl⁻), bromide ion (Br⁻), and iodide ion (I⁻).

According to the embodiments of the present invention, a band gap of the perovskite light absorbing layer 100 is 1.20 eV to 2.30 eV, for example, 1.20 eV, 1.30 eV, 1.40 eV, 1.50 eV, 1.60 eV, 1.70 eV, 1.80 eV, 1.90 eV, 2.00 eV, 2.10 eV, 2.20 eV, or 2.30 eV

According to the embodiments of the present invention, a thickness of the perovskite light absorbing layer 100 is 200 nm to 1000 nm, for example, 200 nm, 300 nm, 400 nm, 500 nm, 600 nm, 700 nm, 800 nm, 900 nm, or 1000 nm.

According to the embodiments of the present invention, the material for forming the electron transport layer 300 includes [6,6]-phenyl C₆₁ methyl butyrate (PC₆₁BM), [6,6]-phenyl C₇₁ methyl butyrate (PC₇₁BM), fullerene C60 (C60), fullerene C70 (C70), tin dioxide (SnO₂), and zinc oxide (ZnO); and the material for forming the electron transport layer 300 is not limited to these materials and may alternatively be derivatives of the these materials and materials doped or passivated by the derivatives. The above materials are electron transport layer materials that can match the electronic energy levels of perovskite, which can stop migration of holes while ensuring electron transport, and a sulfide insert layer can reduce contact resistance and enhance current carrier migration.

According to the embodiments of the present invention, the material for forming the hole transport layer 400 includes at least one of poly[bis(4-phenyl)(2,4,6-trimethylphenyl)amine] (PTAA), 2,2',7,7'-tetra[N,N-bis(4-methoxyphenyl)amino]-9,9'-spirobifluorene (Spiro-OMeTAD), poly-3-hexylthiophene (P3HT), triphenylamine with triptycene as a core (H101), 3,4-ethylenedioxythiophene-methoxytriphenylamine (EDOT-OMeTPA), N-(4-aniline) carbazole-spirobifluorene (CzPAF-SBF), poly(3,4-ethylenedioxythiophene), poly(styrenesulfonate) (PEDOT:PSS), polythiophene, nickel oxide (NiOₓ), molybdenum oxide (MoO₃), copper iodide (CuI), and cuprous oxide (CuO).

According to the embodiments of the present invention, a material for forming the back electrode layer 600 includes at least one of Ag, Cu, C, Au, Al, ITO, AZO, BZO, and IZO.

The present invention further provides a method for preparing the perovskite solar cell described above. The method includes: forming a resistance reduction layer 200 between a perovskite light absorbing layer 100 and an electron transport layer 300 through evaporation. Therefore, the method has all the features and advantages of the perovskite solar cell described above, which are not described again herein. In conclusion, a perovskite solar cell device prepared using this preparation method has a high fill factor. In addition, the method also has the advantage of simple operation.

Technicians can precisely control the thickness of the prepared resistance reduction layer 200 by adjusting evaporation parameters, making the thickness of the resistance reduction layer 200 less than or equal to 3 nm. Specifically, the compactness of the resistance reduction layer 200 can be controlled by adjusting the evaporation rate. During evaporation, the thickness of the resistance reduction layer 200 can be monitored in real time by an instrument, and evaporation is stopped when the resistance reduction layer 200 reaches a specified thickness.

In some specific embodiments of the present invention, the evaporation rate may be 0.005 A/s to 0.03 A/s, for example, 0.01 A/s. Thus, a resistance reduction layer 200 with a compact structure can be obtained.

When the resistance reduction layer 200 is prepared through evaporation, the evaporation rate is not very stable at the beginning, the initial 1 nm of substance obtained by evaporation is discarded, and evaporation is started after the subsequent rate is stable. Specifically, a baffle plate is arranged for covering at the start of evaporation, and the baffle plate is opened after 1 nm of resistance reduction layer is formed through evaporation. After a required thickness is obtained through evaporation, the baffle plate is arranged for covering again.

In some embodiments of the present invention, during preparation of the resistance reduction layer 200, after the evaporation is completed, the method further includes a step of vacuumizing a chamber, followed by subsequent operations after the vacuumizing. Through vacuumizing, residual substances in the chamber can be removed. The vacuumizing may be performed for 20 min to 40 min, for example, 30 min. This enables the obtained perovskite solar cell to have better performance.

According to the embodiments of the present invention, the method includes: providing a transparent electrode layer 500; forming the electron transport layer 300 on a side of the transparent electrode layer 500; forming the resistance reduction layer 200 on a side of the electron transport layer 300 away from the transparent electrode layer 500; forming the perovskite light absorbing layer 100 on a side of the resistance reduction layer 200 away from the electron transport layer 300; forming a hole transport layer 400 on a side of the perovskite light absorbing layer 100 away from the resistance reduction layer 200; and forming a back electrode layer 600 on a side of the hole transport layer 400 away from the perovskite light absorbing layer 100. In this way, a perovskite solar cell with a cis structure as shown in FIG. 2 can be prepared.

According to some other embodiments of the present invention, the method includes: providing a transparent electrode layer 500; forming a hole transport layer 400 on a side of the transparent electrode layer 500; forming the perovskite light absorbing layer 100 on a side of the hole transport layer 400 away from the transparent electrode layer 500; forming the resistance reduction layer 200 on a side of the perovskite light absorbing layer 100 away from the hole transport layer 400; forming an electron transport layer 300 on a side of the resistance reduction layer 200 away from the perovskite light absorbing layer 100, and forming a back electrode layer 600 on a side of the electron transport layer 300 away from the resistance reduction layer 200. In this way, a perovskite solar cell with a trans structure as shown in FIG. 3 can be prepared.

The present invention further provides an electric device. The electric device includes the perovskite solar cell described above. Therefore, the electric device has all the features and advantages of the perovskite solar cell described above, which are not described again herein. In conclusion, the perovskite solar cell in the electric device has excellent performance.

Specifically, the perovskite solar cell can be used as a power source of an electric device to supply power to the electric device. For example, the electric device includes but is not limited to an electric vehicle, an electric bicycle, an electric toy, and an electric tool.

In the examples described below in this application, unless otherwise specified, the reagents used are all commercially available from the market or can be prepared by the methods described in this application.

### Example 1

As shown in FIG. 1, in a perovskite solar cell using lithium sulfide as a modification layer, the trans perovskite solar cell structure was sequentially provided with a transparent electrode layer, a hole transport layer, a perovskite light absorbing layer, a metal sulfide resistance reduction layer, an electron transport layer, and a back electrode layer.
(1) 0.35 cm of ITO was removed from each of the two ends of ITO conductive glass with a size of 2.0 cm*2.0 cm through laser etching, to expose a glass substrate.
(2) The etched ITO conductive glass was ultrasonically cleaned several times with water, acetone, and isopropanol in sequence.
(3) A solvent on the ITO conductive glass was blow-dried under a nitrogen gun, and the ITO conductive glass was further cleaned in a UV ozone machine.
(4) The UV ozone-treated ITO substrate was spin-coated with a 2 mg/mL of PTAA organic hole transport layer at a rate of 5000 rpm/s, and then annealed on a hot table at 100°C for 10 min.
(5) The prepared hole transport layer was spin-coated with a perovskite precursor solution at 1000 rpm/s to 5000 rpm/s, annealed at 100°C for 30 min, and cooled to room temperature, where an active substance of the perovskite light absorbing layer was FA_{0.83}Cs_{0.17}PbI₃.
(6) The obtained sheet was put into an evaporator, after a vacuum degree for evaporation was below 5*10⁻⁴ Pa, 1 nm of lithium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.
(7) The perovskite solar cell obtained through the above steps was denoted as Cell 1.

### Example 2

Except for step (6), the other steps were the same as in Example 1.

(6) 2 nm thick lithium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 2.

### Example 3

Except for step (6), the other steps were the same as in Example 1.

(6) The obtained sheet was put into an evaporator, after a vacuum degree for evaporation was below 5*10⁻⁴ Pa, 3 nm of lithium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 3.

### Example 4

Except for step (6), the other steps were the same as in Example 1.

(6) The obtained sheet was put into an evaporator, after a vacuum degree for evaporation was below 5*10⁻⁴ Pa, 1 nm of potassium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 4.

### Example 5

Except for step (6), the other steps were the same as in Example 1.

(6) 1 nm thick magnesium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 5.

### Example 6

Except for step (6), the other steps were the same as in Example 1.

(6) 1 nm thick arsenic sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 6.

### Example 7

Except for step (6), the other steps were the same as in Example 1.

(6) 1 nm thick indium sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 7.

### Example 8

Except for step (6), the other steps were the same as in Example 1.

(6) 1 nm thick manganese sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 8.

### Example 9

Except for step (6), the other steps were the same as in Example 1.

(6) 1 nm thick cobalt sulfide was evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 9.

### Example 10

Except for step (6), the other steps were the same as in Example 1.

(6) A prepared perovskite film was spin-coated with an organic passivation layer (PCBM; 1 mg/ml; solvent: chlorobenzene; acceleration rotating speed: 5000 rpm/s; spin-coating time: 30 s; and annealing: at 100°C for 10 min); and the obtained sheet was put into an evaporator, after a vacuum degree for evaporation was below 5*10⁻⁴ Pa, 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 10.

### Example 11

Except for step (6), the other steps were the same as in Example 1.

(6) The obtained sheet was put into an evaporator, after a vacuum degree for evaporation was below 5*10⁻⁴ Pa, 1 nm thick lithium fluoride was first evaporated at a rate of 0.02 A/s, then 30 nm of electron transport layer C60 was evaporated at a rate of 0.05 A/s, and ultimately 80 nm of back electrode layer Cu was evaporated at a rate of 0.1 A/s.

The perovskite solar cell obtained in this example was denoted as Cell 11.

### Comparative example 1

(1) 0.35 cm of ITO was removed from each of the two ends of ITO conductive glass with a size of 2.0 cm*2.0 cm through laser etching, to expose a glass substrate.
(2) The etched ITO conductive glass was ultrasonically cleaned several times with water, acetone, and isopropanol in sequence.
(3) A solvent on the ITO conductive glass was blow-dried under a nitrogen gun, and the ITO conductive glass was further cleaned in a UV ozone machine.
(4) The UV ozone-treated ITO substrate was spin-coated with a 2 mg/mL of PTAA organic hole transport layer at a rate of 5000 rpm/s, and then annealed on a hot table at 100°C for 10 min.
(5) The prepared hole transport layer was spin-coated with a perovskite precursor solution at 1000 rpm/s to 5000 rpm/s, annealed at 100°C for 30 min, and cooled to room temperature, where an active substance of the perovskite light absorbing layer was FA_{0.83}Cs_{0.17}PbI₃.
(6) The obtained sheet was put into an evaporator, after a vacuum degree for evaporation was below 5*10⁻⁴ Pa, 30 nm of electron transport layer C60 was evaporated at a rate of 0.05 A/s, and ultimately 80 nm of back electrode layer Cu was evaporated at a rate of 0.1 A/s.
(7) The perovskite solar cell obtained through the above steps was denoted as Cell 12.

### Test method

### 1. Contact resistance of perovskite solar cell

Under irradiation of standard simulated sunlight (AM 1.5G, 100 mW/cm²), the performance of the cell was tested to obtain an I-V curve, and a computer automatically read a contact resistance value from data.

### 2. Photoelectric conversion efficiency of perovskite solar cell

Under irradiation of standard simulated sunlight (AM 1.5G, 100 mW/cm²), the performance of the cell was tested to obtain an I-V curve. Short-circuit current Jsc (measured in mA/cm²), open-circuit voltage Voc (measured in V), maximum light output current Jmpp (measured in mA), and maximum light output voltage Vmpp (measured in V) could be obtained based on the I-V curve and feedback data from a test device. A fill factor FF of the cell was calculated according to a formula FF = Jsc × Voc/(Jmpp × Vmpp), measured in %. Photoelectric conversion efficiency PCE of the cell was calculated according to a formula PCE = Jsc × Voc × FF/Pw, measured in %, where Pw represents input power, measured in mW.

The perovskite solar cells obtained in the above examples and comparative examples were respectively tested according to the above process, and specific values are shown in Table 1.

**Table 1 Influence of different resistance reduction layer materials on device performance**

| Sample name | Resistance reduction layer material | Thickness (nm) | Contact resistance (ohm) | PCE (%) | FF (%) | Voc (V) | Jsc (mA/cm²) |
|---|---|---|---|---|---|---|---|
| Example 1 | Lithium sulfide | 1 | 73.42 | 21.38 | 82.47 | 1.1 | 23.57 |
| Example 2 | Lithium sulfide | 2 | 81.2 | 20.88 | 81.04 | 1.1 | 23.42 |
| Example 3 | Lithium sulfide | 3 | 96.21 | 20.68 | 79.82 | 1.1 | 23.55 |
| Example 4 | Potassium sulfide | 1 | 100.12 | 20.42 | 79.96 | 1.09 | 23.43 |
| Example 5 | Magnesium sulfide | 1 | 98.12 | 20.60 | 79.87 | 1.09 | 23.66 |
| Example 6 | Arsenic sulfide | 1 | 121.12 | 20.21 | 79.88 | 1.09 | 23.21 |
| Example 7 | Indium sulfide | 1 | 107.21 | 20.31 | 78.87 | 1.10 | 23.41 |
| Example 8 | Manganese sulfide | 1 | 134.20 | 19.42 | 76.02 | 1.09 | 23.44 |
| Example 9 | Cobalt sulfide | 1 | 127.91 | 19.92 | 77.45 | 1.09 | 23.43 |
| Example 10 | PCBM | 1 | 133.91 | 20.18 | 78.02 | 1.10 | 23.52 |
| Example 11 | Lithium fluoride | 1 | 109.21 | 20.47 | 79.48 | 1.10 | 23.41 |
| Comparative example 1 | Not found | 0 | 152.44 | 18.64 | 73.45 | 1.08 | 23.50 |

It can be seen from Table 1 that the contact resistance in Examples 1 to 11 is less than that in Comparative example 1, indicating that after the resistance reduction layer is disposed between the perovskite light absorbing layer and the electron transport layer, the contact resistance can be reduced, and the fill factor of the perovskite solar cell device can be increased, making the perovskite solar cell have better performance. In addition, the comprehensive performance of the cells in Examples 1 to 9 is better than that of the cells in Examples 10 and 11, that is, compared with using PCBM and lithium fluoride as the resistance reduction layer materials, using sulfide as the resistance reduction layer material can make the perovskite solar cell have better performance. Moreover, in Examples 1 to 9, the cells in Examples 1 to 5 and Example 7 have better comprehensive performance, that is, the preferred materials for forming the resistance reduction layer are lithium sulfide, potassium sulfide, magnesium sulfide, and indium sulfide. Under this condition, the prepared perovskite solar cells have lower contact resistance, and the perovskite solar cells have better comprehensive performance.

The foregoing describes in detail the embodiments of the present invention. However, the present invention is not limited to the specific details in the above embodiments. Within the technical concept scope of the present invention, various simple modifications can be made to the technical solutions of the present invention, and these simple modifications all fall within the protection scope of the present invention. In addition, it should be noted that the specific technical features described in the above specific embodiments can be combined in any suitable manner without contradiction.

It should be noted that in the description of this specification, descriptions referring to the terms "an embodiment", "some embodiments", "an example", "a specific example", or "some examples" mean the specific features, structures, materials or characteristics described with reference to the embodiment or example are included in at least one embodiment or example of the present invention. In this specification, the illustrative expressions of these terms do not necessarily refer to the same embodiment or example. In addition, the specific features, structures, materials or characteristics described can be combined in any appropriate manner in any one or more embodiments or examples. Besides, without mutual conflict, persons skilled in the art can incorporate and combine different embodiments or examples and features of the different embodiments or examples described in this specification.

Although the examples of the present invention have been shown and described, it can be understood that these examples are illustrative and should not be construed as limitations on the present invention. Persons of ordinary skill in the art can make changes, modifications, substitutions, and transformations to these examples within the scope of the present invention.

## Claims

1. A perovskite solar cell, **characterized in that** the perovskite solar cell comprises: a perovskite light absorbing layer, an electron transport layer, and a resistance reduction layer located between the perovskite light absorbing layer and the electron transport layer.

2. The perovskite solar cell according to claim 1, **characterized in that** a material for forming the resistance reduction layer comprises at least one of metal sulfide, metalloid sulfide, and sulfur-containing organic compound.

3. The perovskite solar cell according to claim 2, **characterized in that** the material for forming the resistance reduction layer comprises at least one of lithium sulfide, potassium sulfide, magnesium sulfide, arsenic sulfide, indium sulfide, manganese sulfide, and cobalt sulfide.

4. The perovskite solar cell according to claim 1, **characterized in that** a thickness of the resistance reduction layer is less than or equal to 3 nm.

5. The perovskite solar cell according to claim 4, **characterized in that** the thickness of the resistance reduction layer is 1 nm to 3 nm.

6. The perovskite solar cell according to claim 1, **characterized in that** the perovskite solar cell further comprises a back electrode layer, a transparent electrode layer, and a hole transport layer; wherein
a structure of the perovskite solar cell satisfies any one of the following conditions:
the transparent electrode layer is located on a side of the electron transport layer away from the resistance reduction layer, the hole transport layer is located on a side of the perovskite light absorbing layer away from the resistance reduction layer, and the back electrode layer is located on a side of the hole transport layer away from the perovskite light absorbing layer; and
the hole transport layer is located on the side of the perovskite light absorbing layer away from the resistance reduction layer, the transparent electrode layer is located on the side of the hole transport layer away from the perovskite light absorbing layer, and the back electrode layer is located on the side of the electron transport layer away from the resistance reduction layer.

7. The perovskite solar cell according to claim 6, **characterized in that** a material for forming the transparent electrode layer comprises at least one of FTO, ITO, AZO, BZO, and IZO.

8. The perovskite solar cell according to claim 6, **characterized in that** a chemical formula of a material for forming the perovskite light absorbing layer is ABX₃ or A₂CDX₆, wherein A is at least one of methylamino, amidino, cesium ion, and rubidium ion, B is at least one of divalent lead ion and divalent tin ion, C is monovalent silver ion, D is trivalent bismuth ion, and X is at least one of chloride ion, bromide ion, and iodide ion.

9. The perovskite solar cell according to claim 6, **characterized in that** a band gap of the perovskite light absorbing layer is 1.20 eV to 2.30 eV.

10. The perovskite solar cell according to claim 6, **characterized in that** a thickness of the perovskite light absorbing layer is 200 nm to 1000 nm.

11. The perovskite solar cell according to claim 6, **characterized in that** a material for forming the electron transport layer comprises at least one of [6,6]-phenyl C₆₁ methyl butyrate, [6,6]-phenyl C₇₁ methyl butyrate, fullerene C60, fullerene C70, tin dioxide, and zinc oxide.

12. The perovskite solar cell according to claim 6, **characterized in that** a material for forming the hole transport layer comprises at least one of poly[bis(4-phenyl)(2,4,6-trimethylphenyl)amine], 2,2',7,7'-tetra[N,N-bis(4-methoxyphenyl)amino]-9,9'-spirobifluorene, poly-3-hexylthiophene, triphenylamine with triptycene as a core, 3,4-ethylenedioxythiophene-methoxytriphenylamine, N-(4-aniline) carbazole-spirobifluorene, poly(3,4-ethylenedioxythiophene), poly(styrenesulfonate), polythiophene, nickel oxide, molybdenum oxide, copper iodide, and cuprous oxide.

13. The perovskite solar cell according to claim 6, **characterized in that** a material for forming the back electrode layer comprises at least one of Ag, Cu, C, Au, Al, ITO, AZO, BZO, and IZO.

14. A method for preparing the perovskite solar cell according to any one of claims 1 to 13, **characterized in that** the method comprises: forming a resistance reduction layer between a perovskite light absorbing layer and an electron transport layer through evaporation.

15. The method according to claim 14, **characterized in that** an evaporation rate is 0.005 A/s to 0.03 A/s.

16. The method according to claim 14, **characterized in that** after the evaporation is completed, the method further comprises a step of vacuumizing a chamber, wherein the vacuumizing is performed for 20 min to 40 min.

17. The method according to claim 14, **characterized in that** the method comprises:
providing a transparent electrode layer;
forming the electron transport layer on a side of the transparent electrode layer;
forming the resistance reduction layer on a side of the electron transport layer away from the transparent electrode layer;
forming the perovskite light absorbing layer on a side of the resistance reduction layer away from the electron transport layer;
forming a hole transport layer on a side of the perovskite light absorbing layer away from the resistance reduction layer; and
forming a back electrode layer on a side of the hole transport layer away from the perovskite light absorbing layer.

18. The method according to claim 14, **characterized in that** the method comprises:
providing a transparent electrode layer;
forming a hole transport layer on a side of the transparent electrode layer;
forming the perovskite light absorbing layer on a side of the hole transport layer away from the transparent electrode layer;
forming the resistance reduction layer on a side of the perovskite light absorbing layer away from the hole transport layer;
forming an electron transport layer on a side of the resistance reduction layer away from the perovskite light absorbing layer; and
forming a back electrode layer on a side of the electron transport layer away from the resistance reduction layer.

19. An electric device, **characterized in that** the electric device comprises the perovskite solar cell according to any one of claims 1 to 13.
